# EUROPEAN PATENT SPECIFICATION

(11) **EP 2 594 021 B1**
(45) Date of publication and mention of the grant of the patent: **13.07.2016**
(21) Application number: 11735945.5
(22) Date of filing: 14.07.2011
(51) Int. Cl.: H03K 17/687, H04R 5/033, H04R 5/04, H02M 1/36

(54) **ZERO POWER DRAIN PUSHBUTTON CONTROLS**
DRUCKKNOPFSTEUERUNGEN MIT NULLLEISTUNGSABGABE
COMMANDES À BOUTONS POUSSOIRS A CONSOMMATION NULLE

(30) Priority: 05.04.2011 US 201113080357; 18.07.2010 US 838477; 18.07.2010 US 838479
(43) Date of publication of application: 22.05.2013
(73) Proprietor: Bose Corporation, Framingham, MA 01701 (US)
(72) Inventor: YAMKOVOY, Paul G., Framingham Massachusetts 01701 (US); BURGE, Benjamin D., Framingham Massachusetts 01701 (US)
(74) Representative: Attali, Pascal
(86) International application number: PCT/US2011/043974
(87) International publication number: WO 2012/012255

(56) References cited:
- WO-A2-2007/103951
- US-A1- 2007 235 754

## Description

### TECHNICAL FIELD

This disclosure relates to monitoring a connection between a headset and an intercom system or radio, to possible responses to the status of the intercom or radio and the connection thereto, and to conserving a headset power source.

### BACKGROUND

There continues to be a desire to provide both operator convenience and conservation of power in headsets, as well as in other forms of personal audio device. Pushbutton switches continue to be more sought-after than more traditional toggle-type switches. An example of circuit using a push-button is disclosed in US 2007/0235757. However, difficulties have been encountered in providing a pushbutton switches that do not also require the use of a combination of electronic components that continuously drain a limited power source (e.g., a battery) of a personal audio device (e.g., a headset) during low power modes that are automatically entered into as an approach to conserving the limited power available from a limited power source.

### SUMMARY

A plurality of normally-open pushbutton switches are coupled to and cooperate with a pair of MOSFETs to provide each pushbutton switch of the plurality of pushbutton switches with a power on switch function for a personal audio device that does not require power to be drawn from a power source to monitor each of the pushbutton switches or to identify which of the pushbutton switches was manually operated to power on the personal audio device while awaiting operation of one of the pushbutton switches to cause the personal audio device to be powered on.

In one aspect, an apparatus includes a plurality of normally-open manually operable switches; a first MOSFET having a first gate coupled to each switch of the plurality of switches, and a first source coupled to a high voltage potential terminal of a power source to receive electric power therefrom; a second MOSFET having a second source coupled to a low voltage potential terminal of the power source; a second drain also coupled to the first gate of the first MOSFET, and a second gate to receive electric power from the power source through at least the first source and a first drain of the first MOSFET; a controller coupled to the first drain and comprising a plurality of switch inputs, wherein each switch of the plurality of switches is coupled to a switch input of the plurality of switch inputs; and wherein the apparatus is arranged such that closing one of the switches of the plurality of switches couples the first gate to the low potential voltage terminal of the power source, placing the first MOSFET into a conductive state, providing a high voltage potential through the first MOSFET to the second gate and to the controller, placing the second MOSFET into a conductive state, thereby a low voltage potential to the first gate to latch the first and the second MOSFETs in a conductive state, in response to which the controller is arranged to latch the state of the plurality of switch inputs and to identify which one of the switches was closed.

In one aspect, a method of operating an apparatus includes waiting for a provision of electric power from a power source caused by a latching interaction of a first MOSFET and a second MOSFET triggered by one normally open switch of a plurality of switches being closed, and latching the state of each switch of the plurality of switches and identifying a switch that was closed to trigger the latching interaction of the first and second MOSFETs.

Other features and advantages of the invention will be apparent from the description and claims that follow.

### DESCRIPTION OF THE DRAWINGS

Figure 1 is a perspective diagram of a headset.
Figure 2 is a block diagram of an electrical architecture employable in the headset of Figure 1.
Figures 3, 4 and 5 are each block diagrams of electrical architecture portions that may be added to the electrical architecture of Figure 2 to add a pushbutton power switch and supporting components that do not draw power while the headset of Figure 1 is in an off state.
Figures 6, 7 and 8 are each block diagrams of electrical architecture portions that may be added to the electrical architecture of Figure 2 to add pushbutton switches serving both as power switches and as user input switches for various designated functions, and supporting components that do not draw power while the headset of Figure 1 is in an off state.

### DETAILED DESCRIPTION

What is disclosed and what is claimed herein is intended to be applicable to a wide variety of headsets, i.e., devices structured to be worn on or about a user's head in a manner in which at least one acoustic driver is positioned in the vicinity of an ear, and in which a microphone is positioned in the vicinity of the user's mouth to enable two-way audio communications. It should be noted that although specific embodiments of headsets incorporating a pair of acoustic drivers (one for each of a user's ears) are presented with some degree of detail, such presentations of specific embodiments are intended to facilitate understanding through examples, and should not be taken as limiting either the scope of disclosure or the scope of claim coverage.

It is intended that what is disclosed and what is claimed herein is applicable to headsets that also provide active noise reduction (ANR), passive noise reduction (PNR), or a combination of both. It is intended that what is disclosed and what is claimed herein is applicable to headsets structured to be connected with at least an intercom system through a wired connection, but which may be further structured to be connected to any number of additional devices through wired and/or wireless connections. It is intended that what is disclosed and what is claimed herein is applicable to headsets having physical configurations structured to be worn in the vicinity of either one or both ears of a user, including and not limited to, over-the-head headsets with either one or two earpieces, behind-the-neck headsets, two-piece headsets incorporating at least one earpiece and a physically separate microphone worn on or about the neck, as well as hats or helmets incorporating earpieces and a microphone to enable audio communication. Still other embodiments of headsets to which what is disclosed and what is claimed herein is applicable will be apparent to those skilled in the art.

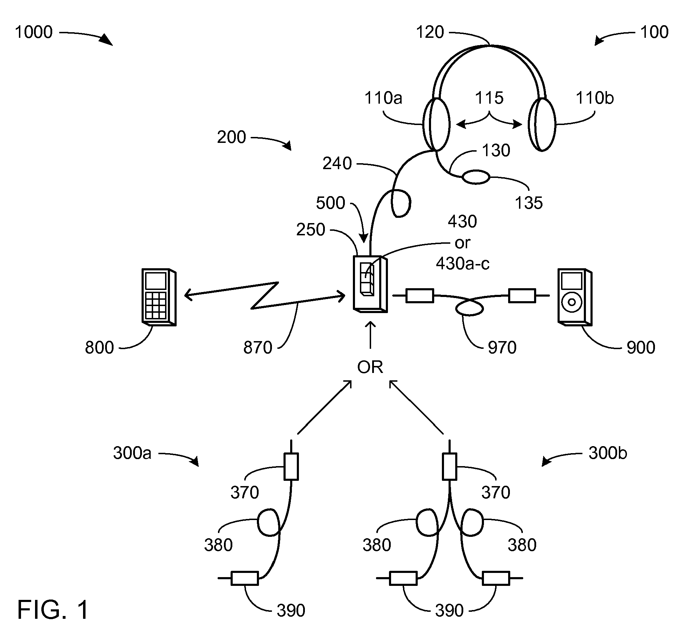

**Figure 1** depicts an embodiment of a headset 1000 having an "over-the-head" physical configuration. The headset 1000 incorporates a head assembly 100, an upper cable assembly 200, and one or the other of a lower cable assembly 300a and a lower cable assembly 300b. The head assembly 100 incorporates a pair of earpieces 110a and 110b that each incorporate an acoustic driver 115, a headband 120 that couples together the earpieces 110a and 110b, and a microphone boom 130 extending from the earpiece 110a to support a communications microphone 135. The upper cable assembly 200 incorporates a control box 250 having a control circuit 500, and an electrically conductive cable 240 that couples the control box 250 to the earpiece 110a. The lower cable assembly 300a incorporates an upper coupling 370 that detachably couples the cable assembly 300a to the control box 250, a lower coupling 390 that detachably couples the cable assembly 300a to an intercom system (not shown), and an electrically conductive cable 380 that couples together the upper coupling 370 and the lower coupling 390. Similarly, the lower cable assembly 300b incorporates an upper coupling 370 that detachably couples the cable assembly 300b to the control box 250, a pair of lower couplings 390 that detachably couples the cable assembly 300b to an intercom system (not shown), and an electrically conductive split form of cable 380 that couples together the upper coupling 370 and the pair of lower couplings 390.

The head assembly 100 is given its over-the-head physical configuration by the headband 120. Depending on the size of each of the earpieces 110a and 110b relative to the typical size of the pinna of a human ear, each of the earpieces 110a and 110b may be either an "on-ear" (also commonly called "supra-aural") or an "around-ear" (also commonly called "circum-aural") form of earcup. As will be explained in greater detail, the provision of an acoustic driver 115 in each of the earpieces 110a and 110b enables the headset 1000 to acoustically output two-channel audio (e.g., stereo audio) to a user. The microphone boom 130 positions the communications microphone 135 is the vicinity of the mouth of a user of the headset 1000 when the head assembly 100 is correctly worn such that the earpieces 110a and 110b overly corresponding ones of the user's ears. However, despite the depiction in Figure 1 of this particular physical configuration of the head assembly 100, those skilled in the art will readily recognize that the head assembly may take any of a variety of other physical configurations. By way of example, alternate embodiments may incorporate only one of the earpieces 110a and 110b to acoustically output only one-channel audio, may incorporate a "behind-the-head" or "behind-the-neck" variant of band in place of the headband 120, may position the communications microphone 135 on a portion of one or the other of the earpieces 110a and 110b (rather than at the end of the microphone boom 130), and/or may be structured to permit one or both of the cable 240 and the microphone boom 130 to be detachable from the earpiece 110a in order to be attached to the earpiece 110b.

The upper cable assembly 200 provides a cable-based coupling of the control box 250 the earpiece 110a (or possibly the earpiece 110b, as just discussed) through the cable 240. As will be explained in greater detail, the control circuit 500 within the control box 250 enables a user of the headset 1000 to interact with more than just an intercom system through the headset 1000. The control circuit 500 may incorporate a wireless transceiver that enables wireless communications via wireless signals 870 (e.g., infrared signals, radio frequency signals, etc.) between the control circuit 500 and a wireless device 800 (e.g., a cell-phone, an audio recording and/or playback device, a two-way radio, etc.) to thereby enable a user to interact with the wifeless device 800 through the headset 1000. The control box 250 may incorporate an auxiliary input enabling the control circuit 500 to be coupled through a cable 970 to a wired device 900 (e.g., an audio playback device, an entertainment radio, etc.) to enable a user to listen through the headset 1000 to audio provided by the wired device 900. Although not specifically depicted in Figure 1, in various possible embodiments, the control box 250 may provide one or more manually-operable controls to enable the user to control one or more aspects of the operation of the headset 1000, possibly including coordinating the transfer of audio among the headset 1000, an intercom system to which the headset may be coupled via one or the other of the lower cable assemblies 300a and 300b, the wireless device 800 and the wired device 900. Further, and although also not depicted in Figure 1, the control circuit 500 may be incorporated into one or both of the earpieces 110a and 110b (or some other portion of the head assembly 100) in addition to or as an alternative to being incorporated within the control box 250, thereby possibly obviating the need for the upper cable assembly 200 to incorporate the control box 250.

Each of the lower cable assemblies 300a and 300b enable the coupling of the headset 1000 to an intercom system of a vehicle or large piece of machinery, including and not limited to, a truck, multi-car train, military vehicle, airplane, seafaring vessel, crane, tunnel boring machine, harvester, combine or tractor. As previously discussed, the lower cable assembly 300a incorporates a single lower connector 390 for coupling to an intercom system, while the lower cable assembly 300b incorporates a pair of lower connectors 390. As will be readily recognized by those having familiarity with such vehicles or large pieces of machinery, despite standards that may exist in some industries, it is not uncommon for manufacturers of different ones of such vehicles or large pieces of machinery to provide intercom systems having characteristics that vary among those manufacturers. Among those varying characteristics is the separation of outgoing and incoming audio signals to be conveyed through two separate connectors by some manufacturers, while other manufacturers choose to combine both outgoing and incoming audio signals to be conveyed through a single connector. Thus, the lower cable assembly 300a is structured to enable the headset 1000 to be coupled to intercom systems employing a single connector through the single lower coupling 390, while the lower cable assembly 300b is structure to enable the headset 1000 to be coupled to intercom systems employing separate connectors through the separate ones of the pair of lower couplings 390. Although a split form of the cable 380 of the cable assembly 300b is depicted as splitting at or in the vicinity of the upper coupling 370, it will be apparent to those skilled in the art that other physical configurations of the cable 380 that accommodate the separation of incoming and outgoing signals among the pair of lower couplings 390 are possible.

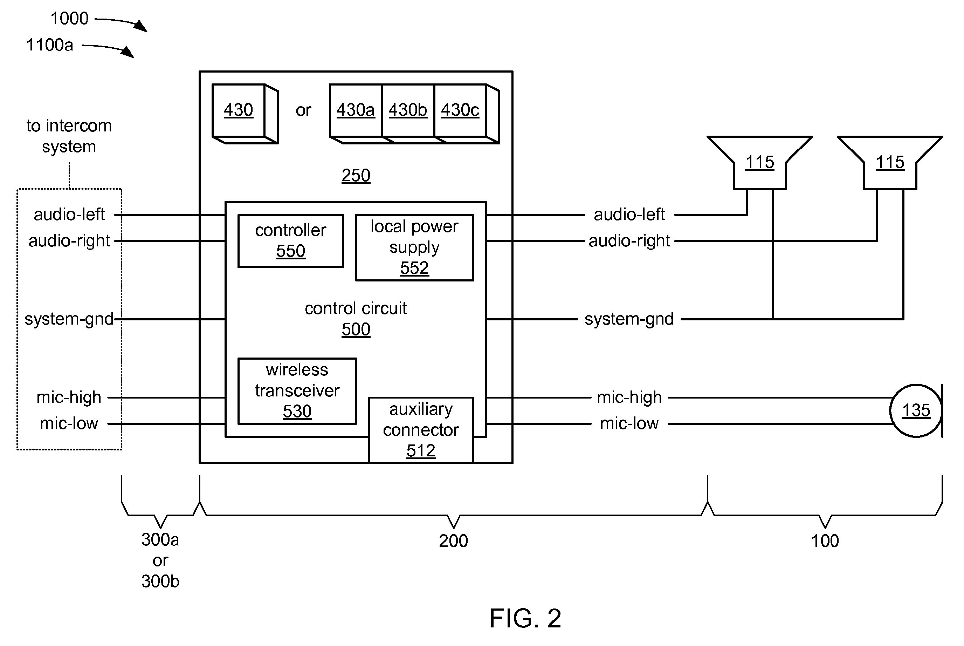

**Figure 2** depicts a possible embodiment of an electrical architecture that may be employed by the headset 1000, including within the control circuit 500. With one or the other of the lower cable assemblies 300a and 300b coupling the control box 250 of upper cable assembly 200 to an intercom system, and with the control box 250 being coupled to the head assembly 100 via the rest of the upper cable assembly 200, left and right audio signals (along with system ground) are able to be conveyed from the intercom system to the acoustic drivers 115, and high and low microphone signals are able to be conveyed from the communications microphone 135 to the intercom system. The control circuit 500 incorporated within the control box 250 monitors user operation of pushbutton switches 430a, 430b and 430c, monitors the coupling of the headset 1000 to an intercom system and controls the conveying of these signals, and controls the local coupling of the system ground of the acoustic drivers 115 to the microphone low signal of the communications microphone 135. In this way, the headset 1000 is able to be employed in interactions by a user with numerous possible combinations of an intercom system, a wireless device 800 and a wired device 900. In employing this electrical architecture, the control circuit 500 incorporates an auxiliary connector 512, a wireless transceiver 530, a controller 550. The controller 550 is coupled to these and other components of the control circuit 500 to monitor and/or control their functions as will be explained in greater detail.

Components of the control circuit 500 combine the left and right audio signals provided by an intercom system (if the headset 1000 is coupled to an intercom system) with audio provided by a wired device (if the headset 1000 is coupled to a wired device via the auxiliary connector 512), and audio received by the wireless transceiver 530 (if active). Where a source of audio provides only single-channel audio (otherwise known as "mono"), the control circuit 500 may combine that audio with only one of the audio-left and audio-right signals, or both. As depicted, the control box 250 and/or at least one of the earpieces 110a and 110b may carry one or more manually-operable controls (e.g., one or more of the switches 430a-c) to enable a user of the headset 1000 to select or in some other way control what sources of audio are ultimately conveyed to the acoustic drivers 115.

The wireless transceiver 530 enables a wireless device (such as the wireless device 800 depicted in Figure 1) to be wirelessly coupled to the control circuit 500 to thereby allow audio received from the wireless device to be summed with other audio and to allow sounds detected by the communications microphone 135 to transmitted to the wireless device. In this way, two-way audio communications is enabled between the headset 1000 and such a wireless device. In various embodiments, the wireless coupling may be through radio frequency (RF) signals, possibly RF signals meant to comply with one or more widely known and used industry standards for RF communication including, and not limited to, the Bluetooth specification promulgated by the Bluetooth SIG based in Bellevue, Washington, or the ZigBee specification promulgated by the ZigBee Alliance based in San Ramon, California.

The controller 550 may be implemented in any of a number of ways. In some embodiments, the controller 550 is a combination of a processing device and a storage device in which is stored a sequence of instructions that is executed by the processing device of the controller 550 to cause that processing device to perform a number of tasks as are described herein. Possible implementations of such a processing device include, and are not limited to, a general purpose central processing unit (CPU), a digital signal processor (DSP), a microcontroller, a sequencer, and a state machine implemented with discrete logic. Possible implementations of such a storage include, and are not limited to, dynamic random access memory (DRAM), static random access memory (SRAM), read-only memory (ROM), electrically erasable programmable read-only memory (EEPROM), any of a variety of other types of volatile and/or non-volatile solid state memory storage technologies, magnetic and/or optical storage media, and any of a variety of other types of storage media.

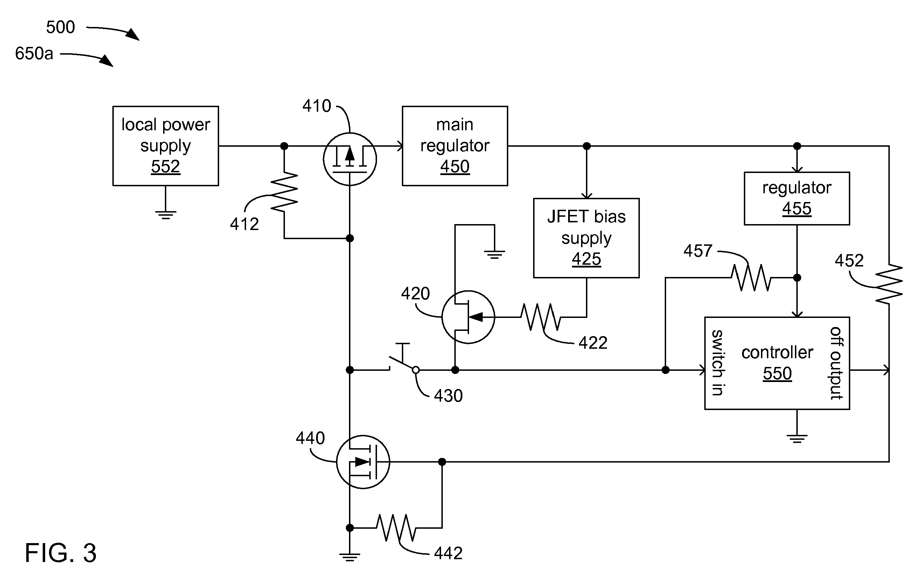

**Figure 3** depicts a portion 650a of an electrical architecture that may be added to the electrical architecture depicted in Figure 2 (or to the electrical architectures of other possible embodiments of the headset 1000) to provide a user of the headset 1000 with a form of pushbutton power switch supported with other components selected and interconnected in a manner that consumes no power from the local power supply 552 until it is used to turn the headset 1000 on. This may be deemed desirable where the local power supply 552 is a power source of limited capacity (e.g., a battery) such that it is seen as undesired to provide a pushbutton power switch that is monitored by the controller 550 in a manner in which the controller 550 must continuously draw power from the local power supply 552, even at times when the headset 1000 appears to be "off" from the perspective of a user.

In the electrical architecture portion 650a, the control circuit 500 further incorporates MOSFETs 410 and 440; resistors 412, 422, 442, 452 and 457; a JFET 420; a JFET bias supply 425; a pushbutton switch 430; and voltage regulators 450 and 455. A high voltage potential terminal of the local power supply 552 is coupled to the resistor 412 and the input of the main voltage regulator 450 through the MOSFET 410 (i.e., is coupled to the source of the MOSFET 410, with the drain of the MOSFET coupled to the input of the main voltage regulator 450). A low voltage potential terminal of the local power supply 552 is coupled to the system-gnd conductor (a.k.a., "ground"). The resistor 412 is coupled to the gate of the MOSFET 410 (as well as to the source), the switch 430 and the drain of the MOSFET 440. The output of the main voltage regulator 450 is coupled to the input of the JFET bias supply 425, the input of the regulator 455 and the resistor 452. The output of the JFET bias supply is coupled to the gate of the JFET 420 through the resistor 422. The output of the regulator 455 is coupled to the controller 550 and both the JFET 420 and the switch 430 through the resistor 457, as well as being coupled to a switch input of the controller 550 through the resistor 457. The resistor 452 is coupled to an off output of the controller 550, to the gate of the MOSFET 440 and to ground (i.e., the system-gnd conductor to which the low voltage potential terminal of the local power source is also coupled) through the resistor 442. The JFET 420 and the source of the MOSFET 440 are also both coupled to ground.

At a time when the headset 1000 is powered off, the gate of the MOSFET 410 is provided with the same high voltage potential of the local power supply 552 as its source through the resistor 412 such that the MOSFET 410 is in a non-conductive state and does not allow current to pass through it. The gate of the MOSFET 440 is provided with the low voltage potential through the resistor 442 such that the MOSFET 440 is also in a non-conductive state and also does not allow current to pass through it. In contrast, the gate of the JFET 420 is provided with a low voltage potential through the resistor 422 from the JFET bias supply 425 such that the JFET enters a conductive state in which it allows current to pass between its source and drain. The JFET bias power supply 425 provides no bias to the gate of the JFET 420 resulting in the JFET 420 being in a conductive state that couples the switch 430 to ground.

Thus, when the headset 1000 is powered off, no power reaches the main regulator 450 from the local power supply 552, and therefore, the JFET bias supply 425, the regulator 455 and the controller 550 are not provided with power. The MOSFET 410 is selected to be the device that gates the flow of electric power from the local power supply 552 to these components due to its ability to provide an extremely high resistance between its source and drain. The MOSFET 410 is also selected due to its lack of current flow through its gate such that high voltage potential of the output of the local power supply 552 is able to be provided through the resistor 412 to the gate of the MOSFET 410 without the MOSFET 410 providing a path for current flow through its gate that would eventually drain the local power supply 552.

It is important to note that, technically speaking, there is still a leakage current that flows through the MOSFETs 410 and 440 while in their non-conductive states. However, as those skilled in the art will already recognize, variants of MOSFETs are available in which this leakage current is so very small, that the leakage between the poles within a battery, the leakage between two contacts of a mechanical switch separated by open air and the leakage between two adjacent traces on typical circuitboards can each be greater than the leakage through some types of MOSFETs that may be employed as the MOSFETs 410 and 440. Therefore, in stating that the circuits depicted in each of the electrical architecture portion 650a does not draw power from the local power supply 552, it is being stated that effectively, the current flow from the local power supply through either of the MOSFETs 410 and 440 is so very negligible that it can be ignored to the extent of being able to say that there is no current flow. In effect, where the local power supply 552 is a battery, the local power supply 552 will literally drain itself of power through the inherent self-leakage of typical batteries long before any other portion of the electrical architecture portion 650a will do so.

Therefore, as long as the high voltage potential of the local power supply 552 continues to be provided to the gate of the MOSFET 410, no current flows from the local power supply 552 to the other components depicted in Figure 10. Yet, the JFET 420 is in a conductive state in which it serves to couple the normally-open pushbutton switch 430 to ground. When a user operates the pushbutton switch 430 to close it, the gate of the MOSFET 410 is then coupled through the pushbutton switch 430 and the JFET 420 to ground, thereby removing the high voltage potential previously provided to the gate of the MOSFET 410. With this change to the low potential of the ground being applied to the gate of the MOSFET 410, the MOSFET 410 responds by allowing current to flow through between its source and drain such that the main regulator 450 is then provided with electric power from the local power supply. In turn, the main regulator provides electric power (at one regulated voltage) to the gate of the MOSFET 440 through the resistor 452. The MOSFET 440 responds to the provision of the high voltage potential of the output of the main regulator 450 through the resistor 452 to its gate by switching to being in a conductive state such that it couples the gate of the MOSFET 410 through its own source and drain. This interaction between the MOSFETs 410 and 440 serves to latch both MOSFETs in their conductive state such that the MOSFET 410 continues to allow current to flow from the local power supply 552 to the main regulator 450 and the MOSFET 440 continues to couple the gate of the MOSFET 410 to ground.

The main regulator 450 also provides power to the regulator 455, which in turn, provides electric power to the controller 550 (at another regulated voltage) and provides a positive voltage potential to the conductor coupling the pushbutton switch 430 to an input of the controller 550. Further, an output of the controller 550 is coupled to the conductor coupling the resistor 452 to the gate of the MOSFET 440. It is through this conductor coupling the output of the controller 550 to the gate of the MOSFET 440 that the controller 550 is able to autonomously turn off the headset 1000 by pulling this conductor down to a low voltage potential, such that the MOSFET 440 ceases to couple the gate of the MOSFET 410 to ground, thereby undoing the latching interaction between the MOSFETs 410 and 440.

The main regulator 450 further provides electric power to the JFET bias supply 425, which in turn, provides a negative voltage potential to the gate of the JFET 420 through the resistor 422. The JFET 420 responds to the change from a low voltage potential to a negative voltage potential at its gate by switching to a non-conductive state such that it no longer couples the pushbutton switch 430 through its source and drain to ground (i.e., the system-gnd conductor). With one side of the pushbutton switch 430 now being coupled to ground through the MOSFET 440, and with the other side of the pushbutton switch 430 being coupled to the switch input of the controller 550 and the pull-up resistor 457, the normally-open pushbutton switch 430 is now able to serve as an input control to the controller 550 that is operable by a user of the headset 1000 to control various aspects of the operation of the headset 1000. The pull-up resistor 457 pulls the voltage potential at the switch input of the controller 550 to a high voltage, and closing the switch 430 couples the switch input of the controller 550 through the switch 430 and the MOSFET 440 (now in a conductive state) to ground (i.e., the low potential of the system-gnd conductor).

The controller 550 may be or may incorporate a processing device that executes a routine made up of a sequence of instructions stored within a storage of the controller 550 that causes the processing device to monitor the switch input of the controller 550 for instances of the switch input being pulled down to a low voltage potential, thereby effectively monitoring the state of the switch 430. Execution of the routine by the processing device may put in place various responses to particular sequences of operation of the switch by a user of the headset 1000, thereby possibly allowing the user of the headset 1000 to control various features of its functionality through differing combinations of relatively rapid sequences of button presses and/or button presses of particular durations. By way of example, a quick pressing of the switch 430 two times in rapid succession (what might be called a quick "double-press") may adjust a volume with which audio is acoustically output by the acoustic drivers 115. By way of another example, a single button press lasting a minimum of a predetermined number of seconds (what might be called a "press-and-hold") may signal the controller (i.e., the processing device of the controller) to turn off the headset 1000. Thus, in this way, the switch 430 may also be used as an "off switch" by the user.

This dual use of the switch 430 as both the "on" button and the "off" button is thereby accomplished with the "on" function of the switch 430 being accomplished through the latching interaction of the MOSFETs 410 and 440 without any participation by the controller 550, while the "off" function of the switch 430 does require action by the controller 550 to accomplish. This can provide the headset 1000 with a useful "failsafe" feature in which the headset 1000 can be turned "on" such that at least basic functions are fully powered, even if the controller 550 is in some way malfunctioning. For operators of vehicles or large machinery where being able to use the headset 1000 to communicate with others without interruption is extremely important (e.g., a pilot in an airplane, an operator of a submersible vehicle, etc.).

As those skilled in the art of the operation of processing devices executing sequences of routines are well aware, even where a routine does not contain an error that causes a processing device to act unpredictably, memory errors, static discharge events, overheating of components, etc., can cause a processing device to cease to execute a sequence of instructions correctly, such that it becomes unresponsive. In more conventional pushbutton on switch controls, where a processing device is relied upon to repeatedly monitor a switch for an instance of it being operated to turn on a device, an event causing the processing device to cease to execute instructions correctly can easily result in a user's use of that switch to turn on that device being entirely ignored. In contrast, the decided lack of reliance on the controller 550 to in any way participate in responding to a user's operation of the switch 430 to turn on the headset 1000 means that the headset 1000 can be turned on by a user and used even where the controller 550 is utterly unresponsive, thereby helping to ensure that the user will be able to use the headset 1000 to continue to engage in necessary communications, even with such a malfunction in progress.

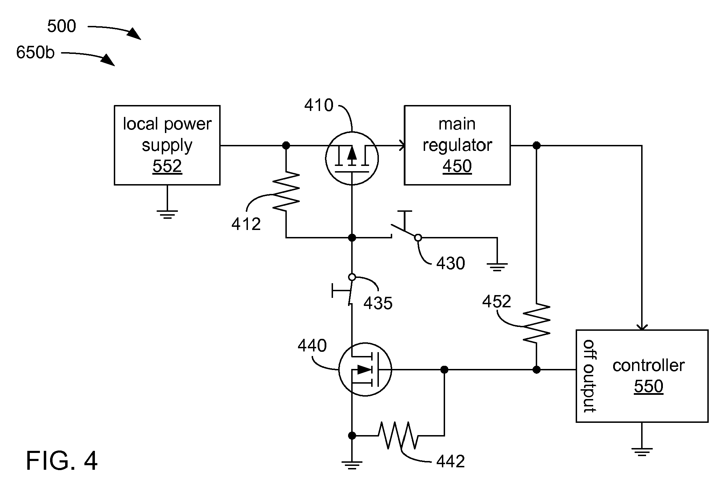

**Figure 4** depicts an alternate portion 650b of an electrical architecture that may be added to the electrical architecture depicted in Figure 2 (or to the electrical architectures of other possible embodiments of the headset 1000) to provide a user of the headset 1000 with a form of dual pushbutton power switch supported with other components selected and interconnected in a manner that consumes no power from the local power supply 552 until it is used to turn the headset 1000 on. The electrical architecture portion 650b differs from the electrical architecture portion 650a in that numerous components of the electrical architecture portion 650a have been removed, and a normally closed switch 435 has been added.

Again, the local power supply 552 is coupled to the resistor 412 and the input of the main voltage regulator 450 through the MOSFET 410. The resistor 412 is coupled to the gate of the MOSFET 410, the switch 430 and the MOSFET 440 through the switch 435. The output of the main voltage regulator 450 is coupled to the controller 550 and the resistor 452. The resistor 452 is coupled to an off output of the controller 550, to the gate of the MOSFET 440 and to ground (i.e., the system-gnd conductor) through the resistor 442. The MOSFET 440 is also both coupled to ground.

At a time when the headset 1000 is powered off, the gate of the MOSFET 410 is provided with the same high voltage potential of the local power supply 552 as its source through the resistor 412 such that the MOSFET 410 is in a non-conductive state and does not allow current to pass through it. The gate of the MOSFET 440 is provided with the low voltage potential through the resistor 442 such that the MOSFET 440 is also in a non-conductive state and also does not allow current to pass through it. Therefore, as long as the high voltage potential of the local power supply 552 continues to be provided to the gate of the MOSFET 410, no current flows from the local power supply 552 to the other components depicted in Figure 11.

When a user operates the pushbutton switch 430 to close it, the gate of the MOSFET 410 is then coupled through the pushbutton switch 430 and the JFET 420 to ground (i.e., the system-gnd conductor), thereby removing the high voltage potential previously provided to the gate of the MOSFET 410. With this change to the low potential of the ground being applied to the gate of the MOSFET 410, the MOSFET 410 responds by allowing current to flow through between its source and drain such that the main regulator 450 is then provided with electric power from the local power supply. In turn, the main regulator provides electric power (at one regulated voltage) to the gate of the MOSFET 440 through the resistor 452. The MOSFET 440 responds to the provision of the high voltage potential of the output of the main regulator 450 through the resistor 452 to its gate by switching to being in a conductive state such that it couples the gate of the MOSFET 410 through its own source and drain. This interaction between the MOSFETs 410 and 440 serves to latch both MOSFETs in their conductive state such that the MOSFET 410 continues to allow current to flow from the local power supply 552 to the main regulator 450 and the MOSFET 440 continues to couple the gate of the MOSFET 410 to ground.

The main regulator 450 also provides power to the controller 550. Further, an output of the controller 550 is coupled to the conductor coupling the resistor 452 to the gate of the MOSFET 440. It is through this conductor coupling the output of the controller 550 to the gate of the MOSFET 440 that the controller 550 is able to autonomously turn off the headset 1000 by pulling this conductor down to a low voltage potential, such that the MOSFET 440 ceases to couple the gate of the MOSFET 410 to ground, thereby undoing the latching interaction between the MOSFETs 410 and 440. The normally-closed switch 435 provides a mechanism by which a user is able to turn off the headset 1000 by directly breaking the coupling of the gate of the MOSFET 410 to ground through the MOSFET 440 when the switch 435 is operated from its normally-closed state to an open state. This undoes the latching interaction between the MOSFETs 410 and 440, causing the MOSFET 410 to return to a non-conductive state, thereby depriving the MOSFET 440 of the high voltage potential presented to its gate through the regulator 450 and the resistor 452. The provision of both of the switches 430 and 435 to enable the headset 1000 to be both turned on and turned off without involvement of the controller 550 may be deemed desirable where the ability to turn the headset 1000 off despite a malfunction of the controller 550 is wanted.

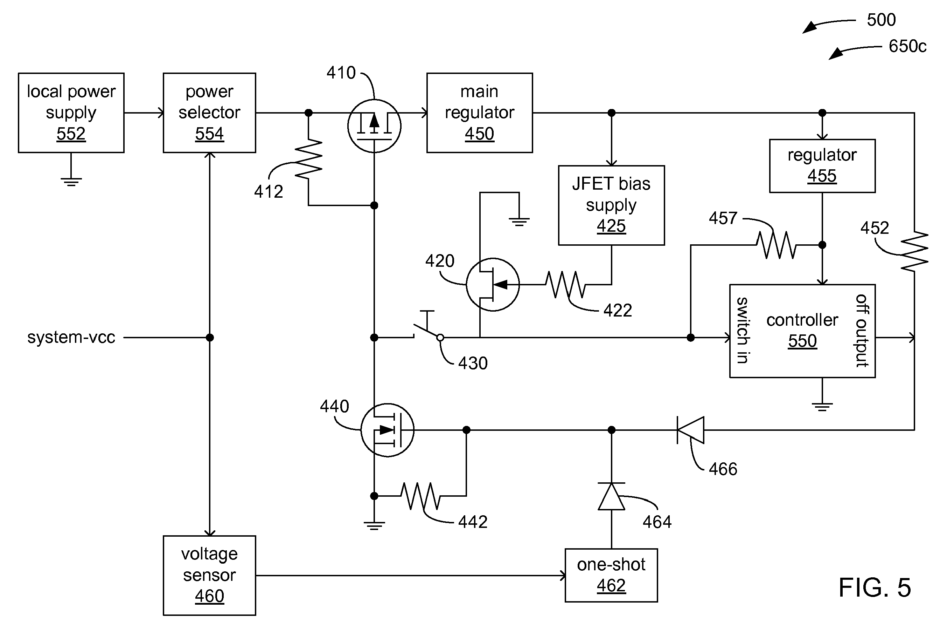

**Figure 5** depicts a portion 650c of yet another electrical architecture that may be added to either of the electrical architecture depicted in Figure 2 (or to the electrical architectures of other possible embodiments of the headset 1000) to provide a user of the headset 1000 with a form of pushbutton power switch supported with other components selected and interconnected in a manner that consumes no power from the local power supply 552 until it is used to turn the headset 1000 on. The electrical architecture portion 650c is substantially similar to the electrical architecture portion 650a, with the exception that the electrical architecture portion 650c adds the facility to cause the headset 1000 to be automatically turned on when coupled to an intercom system that provides electric power via a system-vcc conductor, in addition to providing the ability to automatically switch to drawing power from the local power supply 552 when power is not provided by an intercom system.

In the electrical architecture portion 650c, the power selector 554 is interposed between the local power supply 552 and both the MOSFET 410 and the resistor 412 to enable the power selector 554 to automatically select between power provided by the local power supply 552 and power provided via the system-vcc conductor. In some embodiments, the power selector 554 is a power multiplexer that automatically selects whichever power source provides power with a greater voltage, and the local power supply is selected and/or configured to always provide power with a lesser voltage than the electric power expected to be received from an intercom system via the system-vcc conductor. In this way, the power selector 554 is caused to always select the electric power provided by the system-vcc conductor when that electric power is available so as to attempt to conserve the electric power provided by the local power supply 552.

The system-vcc conductor is also coupled to a voltage sensor 460 that is further coupled to a one-shot 462 (also commonly referred to as "monostable multivibrator" or "mono-shot"). The voltage sensor 460 monitors the system-vcc conductor for transitions in the state of the system-vcc from a low voltage potential (relative to the system-gnd conductor) associated with no power being provided by an intercom system to a high voltage potential associated with such power being provided. Where such transitions occur, the voltage sensor 460 electrically signals the one-shot 462 to inject a pulse of a high voltage potential through a diode 464 to the gate of the MOSFET 440. The length of the high potential pulse output by the one-shot 462 is selected to ensure that the MOSFET 440 is put into a conductive state with a high voltage potential at its gate for a long enough time to cause the MOSFET 410 to enter into a conductive state that enables electric power to be provided to the main regulator 450 (now from the system-vcc conductor), which in turn, causes a high voltage potential to be provided to the gate of the MOSFET 440 through the resistor 452 and through another diode 466. This has the effect of causing the MOSFETs 410 and 440 to engage in a latching interaction. The diodes 464 and 466 serve to protect the main regulator 450 and the one-shot 462 from damaging one another.

It should be noted that although much of the discussion of the power control features, including actions taken by the controller 550 in response to changing circumstances to turn on or off components, and including the latching interaction and zero power drain of the MOSFETs 410 and 440 in conjunction with the switch 430, has centered on the headset 1000, and even more particularly to the user of the headset 1000 with an intercom of an airplane, it should be noted that these power control features may also be employed in other personal audio devices. Such other personal audio devices include, but are not limited to, headphones (including in-ear, over-the-ear, and around-the-ear variants), walkie talkies, corded microphones for two-way radios, wireless headsets, pairs of headphones (with or without ANR capability), etc. These features are believed to be of use in any form of personal audio device in which there is need to conserve electric power provided by a power source of limited capacity.

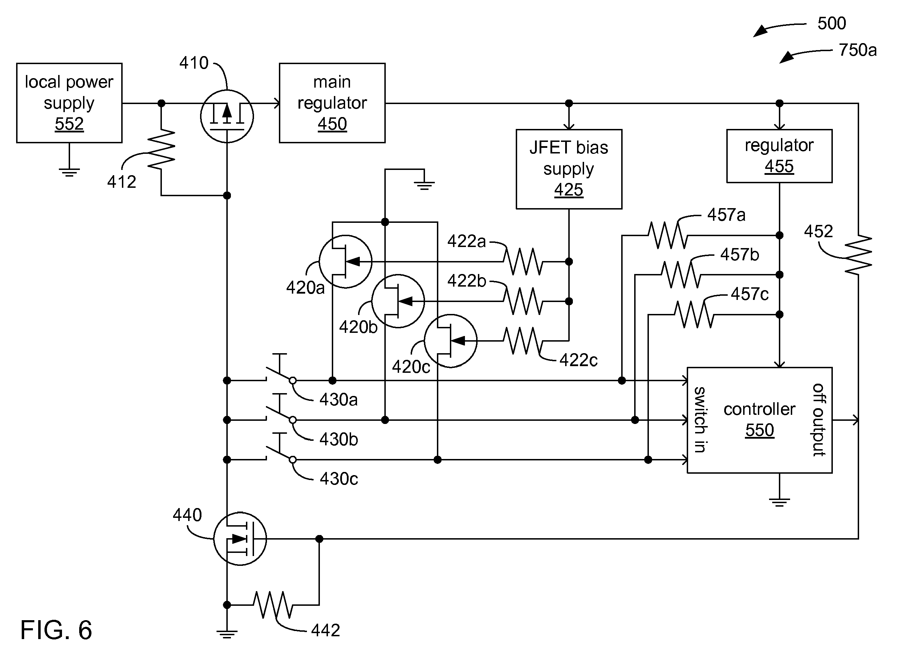

**Figure 6** depicts a portion 750a of an electrical architecture that may be added to either of the electrical architecture depicted in Figure 2 (or to the electrical architectures of other possible embodiments of the headset 1000) to provide a user of the headset 1000 with multiple pushbutton switches, each of which may perform a function entirely unrelated to serving as a power on or power off switch, but each of which is capable of serving as at least a power on switch, and each of which supported with other components selected and interconnected in a manner that consumes no power from the local power supply 552 until it is used to turn the headset 1000 on. The electrical architecture portion 750a is substantially similar to the electrical architecture portion 650a, with the exception that the electrical architecture portion 750a adds the facility to cause the headset 1000 to be turned when any of these pushbutton switches is operated while the headset 1000 is powered off.

In the electrical architecture portion 750a (in comparison to what is depicted of the electrical architecture portion 650a), the combination of single JFET 420 and single resistor 422 is replaced with multiple JFETs 420a, 420b and 420c and multiple corresponding resistors 422a, 422b and 422c; the single pushbutton switch 430 is replaced with multiple pushbutton switches 430a, 430b and 430c (each one of which corresponds to one of the JFETs 420a-c and one of the resistors 422a-c); the single resistor 457 is replaced with multiple resistors 457a, 457b and 457c (each one of which corresponds to one of the JFETs 420a-c, one of the resistors 422a-c and one of the pushbutton switches 430a-c, respectively). Further, the single "switch in" input of the controller 550 used in the electrical architecture portion 650a to monitor the state of the single pushbutton switch 430 is replaced with multiple "switch in" inputs, each of which monitors the state of one of the multiple pushbutton switches 430a-c. In essence, the combination of and the couplings among the JFET 420, the pushbutton switch 430, the resistor 457 and the controller 550 of the electrical architecture portion 650a has been replicated multiple times in the electrical architecture portion 750a. The manner in which each of these replicated combinations interact to cause the latching interaction between the MOSFETs 410 and 440 to power on the headset 1000 is identical to the previously described interaction among the JFET 420, the pushbutton switch 430, the resistor 457 and the one "switch in" input of the controller 550. Also, the manner in which each of these replicated combinations interact to enable the provision of input by a user to the controller 550 is also identical to the previously described interaction among the JFET 420, the pushbutton switch 430, the resistor 457 and the one "switch in" input of the controller 550. As a result, where there was only a single pushbutton switch 430 depicted in the electrical architecture portion 650a as being capable of being employed to cause the latching engagement between the MOSFETs 410 and 440 to power on the headset 1000, the electrical architecture 750a has multiple pushbutton switches 430a-c that are capable of being so employed.

The provision of multiple pushbutton switches that are each capable of causing the headset 1000 provides a convenience feature for the benefit of a user of the headset 1000, and provides an opportunity to reduce the quantity and complexity of the manually-operable controls carried the headset 1000. More simply put, with multiple ones of the pushbutton (or other) switches (if not all of such switches) being made capable of serving as a power switch for powering on the headset 1000, the need for a particular pushbutton switch to serve as a distinct power switch (at least while the headset 1000 is powered off) is eliminated. Each of the pushbutton switches 430a-c is able to be operated to control an aspect of the function of the headset 1000 (e.g., "mute," "volume up," "volume down," "input select," etc.), and none of the pushbutton switches need be "wasted" by being dedicated to serving as a power on switch. This is based on an assumption that a user would not press one of the pushbutton switches 430a-c that has been assigned such a function as "input select" or "volume up" or "mute" unless the user is choosing to operate the headset 1000, and thus, it can be assumed that a user who is pressing one the pushbutton switches 430a-c desires that the headset 1000 be powered on, if it isn't powered on, already. Thus, if the headset 1000 is powered off and a user desires to power it on, that user need only press the one of the pushbutton switches 430a-c that corresponds to the first command input that the user desires to provide to the headset 1000 without having to begin with the extra step of pressing a pushbutton switch that has been dedicated to serve as the switch for powering on the headset 1000 when it is off. In other words, the user can immediately proceed to operating the manually-operable controls of the headset 1000 without having to first take specific steps to cause the headset 1000 to be powered on.

To enable the pushbutton switches 430a-c to be used to serve these simultaneous roles of both powering on the headset 1000 and accepting being operated by a user as an indication of a specific user input, the controller 550 latches the states of each of its "switch in" inputs quickly enough after being provided with power (through the MOSFET 410, the main regulator 450 and the regulator 455) as to capture which one of the pushbutton switches 430a-c was pressed by a user while that user is still pressing that one of the pushbutton switches 430a-c (i.e., latches quickly enough that the user has not yet been able to release that one of these pushbutton switches before latching occurs). In this way, for example, the controller 550 is able to distinguish between use of a "mute" button and an "input select" button to power on the headset, and is able to either immediately mute the microphone 135 or to immediately select a desired input upon the powering on of the headset 1000.

To effectively latch the states of each of the pushbutton switches 430a-c once the controller 550 is provided with power, the latching of the "switch in" inputs of the controller 550 is timed to occur shortly after the gates of the JFETs 420a-c are provided with a negative voltage potential such that all three of the JFETs 420a-c are caused to enter non-conductive states in which they cease to ground the conductors coupling each of the pushbutton switches 420a-c to the "switch in" inputs of the controller 550 and corresponding ones of the resistors 457a-c. With the cessation of such grounding, those same conductors are able to be pulled up to a positive potential voltage output of the regulator 455 through separate ones of the resistors 457a-c. And with the resistors 457a-c acting as pull-up resistors, the controller 550 is able to distinguish which one of the pushbutton switches 430a-c is being pressed by the user, since that one of these pushbutton switches will cause its associated one of these conductors to be pulled low by being coupled through that one of these pushbuttons switches to the conductor coupling the JFETs 410 and 440 (which will be at a low potential voltage as part of the previously described latching interaction between them). Thus, upon being provided with power by the regulator 455, the controller 550 latches the state (i.e., the voltage levels) of the conductors coupling the switches 430a-c to its "switch in" inputs (at a time after the JFETs 420a-c have entered a non-conductive state, but before the user has ceased pressing whichever one of the pushbutton switches 430a-c that the user is pressing), and the pushbutton switch being pressed by the user is the one that corresponds to whichever one of those conductors is at a low voltage level when the latching occurs.

Thus, for example, a user is able to power on the headset 1000 by pressing whichever one of the pushbutton switches 430a-c has been designated as being the "mute" button, or by pressing whichever one of the pushbutton switches 430a-c has been designated as being the "input select" button. A processing device of the controller 550 executes a sequence of instructions of a control routine stored within the controller 550 that causes that processing device to examine the latched states of the conductors coupling the pushbutton switches 430a-c to the "switch in" inputs of the controller 550. If the one of those conductors corresponding to the one of the pushbutton switches 430a-c designated as the "mute" button was latched in a low voltage potential state, then the controller 550 is caused by the sequence of instructions to mute the microphone 135 shortly after the headset 1000 is powered on. If, instead, the one of those conductors corresponding to the one of the pushbutton switches 430a-c designated as the "input select" button was latched in a low voltage potential state, then the controller 550 is caused by the sequence of instructions to select whatever audio input was specified by the user's action of pressing that one of the pushbutton switches 430a-c and convey the audio provided at that audio input to the acoustic drivers 115.

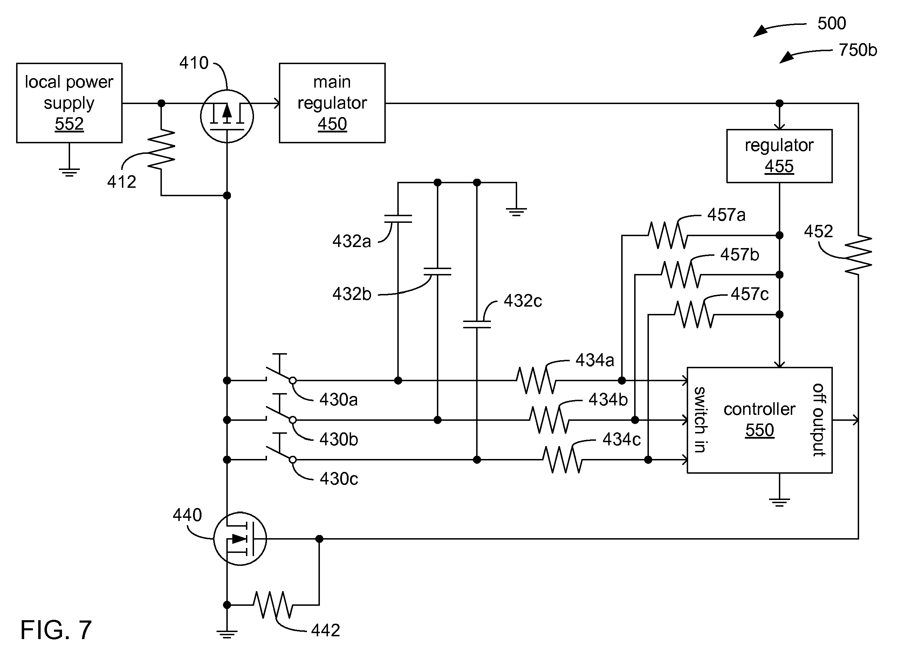

**Figure 7** depicts another portion 750b of an electrical architecture that may be added to either of the electrical architecture depicted in Figure 2 (or to the electrical architectures of other possible embodiments of the headset 1000) to provide a user of the headset 1000 with multiple pushbutton switches, each of which may perform a function entirely unrelated to serving as a power on or power off switch, but each of which is capable of serving as at least a power on switch, and each of which supported with other components selected and interconnected in a manner that consumes no power from the local power supply 552 until it is used to turn the headset 1000 on. The electrical architecture portion 750b is substantially similar to the electrical architecture portion 750a, with the exception that the use of JFETs to initially provide low potentials to the switches 430a-c has been replaced with RC networks that allow the "switch in" inputs to also be operated as outputs.

In the electrical architecture portion 750b (in comparison to what is depicted of the electrical architecture portion 750a), the JFETs 420a-c, the resistors 422a-c and the JFET bias supply 426 have all been removed; and instead, each of the conductors coupled to the one of the switches 430a-c that was selectively coupled to ground through one of the JFETs 420a-c is now coupled to ground through corresponding ones of capacitors 432a-c, and each of these conductors is now coupled to one of the "switch in" inputs of the controller 550 through a corresponding one of resistors 434a-c. Each combination of one of the resistors 434a-c and corresponding one of the capacitors 432a-c forms an RC network that aids in coupling corresponding ones of the switches 430a-c to ground prior to the MOSFETs 410 and 440 engaging in the latching interaction that results in electric power being provided to the regulator 455, and each of these combinations of resistor and capacitor aids the controller 550 in latching the state of corresponding ones of the switches 430a-c soon enough following the controller 550 being provided that the identity of which one of the switches 430a-c was pressed by a user can be determined.

Additionally, the coupling of each of the switches 430a-c to its corresponding one of the "switch in" inputs of the controller 550 enables those same inputs to be further coupled to inputs of still other components (not shown) and for the same inputs to the controller 550 to now additionally be used as outputs convey signals to those inputs of those other components. It is preferred that a processing device of the controller 550 that executes a sequence of instructions of a control routine stored within the controller 550 monitor current operating conditions of the headset 1000 to preferably refrain from operating one or more of the "switch in" inputs as outputs at times when there is a higher likelihood of a user of the headset 1000 operating particular ones of the switches 430a, 430b or 430c such that a given one or more of the "switch in" inputs may be needed to monitor for corresponding ones of the switches 430a-c for an indication of such an action by a user.

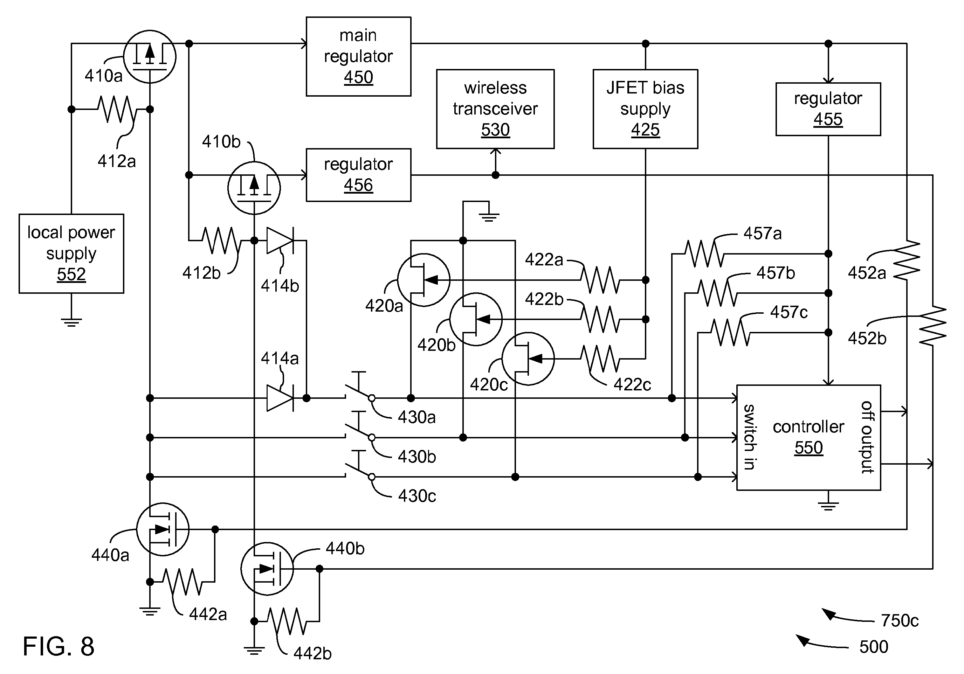

**Figure 8** depicts still another portion 750c of an electrical architecture that may be added to either of the electrical architecture depicted in Figure 2 (or to the electrical architectures of other possible embodiments of the headset 1000) to provide a user of the headset 1000 with multiple pushbutton switches, each of which may perform a function entirely unrelated to serving as a power on or power off switch, but each of which is capable of serving as at least a power on switch, and each of which supported with other components selected and interconnected in a manner that consumes no power from the local power supply 552 until it is used to turn the headset 1000 on. The electrical architecture portion 750c is substantially similar to the electrical architecture portion 750a, with the exception that the electrical architecture portion 750c subdivides the provision of power from a power source to enable there being two variants of the "on" state of the headset 1000.

In the electrical architecture portion 750c (in comparison to what is depicted of the electrical architecture portion 750a), a second pair of MOSFETs 410b and 440b and a second trio of resistors 412b, 442b and 452b are added that roughly correspond in function to the MOSFETs 410 and 440 and the resistors 412, 442 and 452 of the electrical architecture portion 750a. Further, for sake of clarity of discussion regarding this electrical architecture portion 750c, the MOSFETs 410 and 440 and the resistors 412, 442 and 452 of the electrical architecture portion 750a have been relabeled as MOSFETs 410a and 440a and resistors 412a, 442a and 452a, respectively. Further, another regulator 456 has been added in parallel with the main regulator 450 (however, this new regulator 456 could be added in parallel with the regulator 455, instead, depending on power requirements) to separately provide electric power having a regulated voltage to the wireless transceiver 530. Still further, the manner in which the pushbutton switch 430a is coupled to the conductor coupling the MOSFETs 410a and 440a has been altered such that a diode 414a has been interposed between the pushbutton switch 430a and that conductor coupling the MOSFETs 412a and 442a. Correspondingly, another diode 414b has been similarly interposed between the pushbutton switch 430a and a conductor that similarly couples the MOSFETs 410b and 440b.

The manner in which the pushbutton switches 430a-c and the MOSFETs 410a and 440a interact in the electrical architecture portion 750c are identical to the manner in which the pushbutton switches 430a-c and the MOSFETs 410 and 440 interact in the electrical architecture portion 750a (including in the latching behavior between the MOSFETs 410 and 440, and correspondingly between the MOSFETs 410a and 440a to power on the headset 1000). The addition of the diode 414a between the pushbutton switch 430a and the conductor coupling the MOSFETs 410a and 440a does not alter this interaction among these components. However, with the addition of the MOSFETs 410b and 440b, the regulator 456, and the resistors 412b, 442b and 452b, the ability to separately power on the wireless transceiver 530 is added. And, with the coupling of the pushbutton switch 430a to the conductor coupling the MOSFETs 410b and 440b through the diode 414b, it is the pushbutton switch 430a that may be operated by a user of the headset 1000 to power on the wireless transceiver 530 along with the rest of the headset 1000.

The addition of such capability to the pushbutton switch 430a assumes that the pushbutton switch 430a is designated as controlling a function related to the use of the wireless transceiver 530 (e.g., forming a wireless point-to-point link with the wireless device 800 depicted in Figure 1, placing or answering a cellular telephone call, acting as the "push-to-talk" where the headset 1000 is employed in with an intercom or two-way radio, etc.). Thus, where the headset 1000 is powered off, a user pressing either of the pushbutton switches 430b or 430c will cause the powering on of the headset 1000 in the manner that has been described, but without powering on the wireless transceiver 530. This prevents a consumption of power from the local power supply 552 by the wireless transceiver 530 at a time when the user presumably does not desire to make use of the wireless transceiver 530 (presuming that the pushbutton switches 430b and 430c provide control over functions that don't necessarily require the wireless transceiver 530 to be powered on). Alternatively, where the headset 1000 is powered off, a user pressing the pushbutton switch 430a will cause the powering on of the headset 1000 in the manner that has been described, as well as the powering on of the wireless transceiver 530 as a result of the MOSFETs 410b and 440b being caused to engage in a latching interaction that is substantially the same as the latching interaction engaged in by the MOSFETs 410a and 440a.

In a manner substantially identical to what was earlier described with regard to the electrical architecture portion 750a, the controller 550 in the electrical architecture portion 750c examines the state of the conductors coupling the pushbutton switches 430a-c to its "switch in" inputs shortly after being provided with power to determine which of these pushbutton switches were operated by a user to power on the headset 1000. A processing device of the controller 550 that executes a sequence of instructions of a control routine stored within the controller 550 may employ this information to determine whether or not the wireless transceiver 530 is also powered on, or may more directly monitor the wireless transceiver 530 for a signal indicating whether it is powered on, or not. Further, following the powering on of the headset 1000, the wireless transceiver 530 may be subsequently caused to be either powered on or powered off under the control of a processing device of the controller 550 executing a control routine in response to detecting operation of the pushbutton switch 430a (and/or another pushbutton switch). More precisely, where the controller 550 receives an indication via its "switch in" inputs that one of the pushbutton switches 430a-c has been operated in a manner that indicates that the wireless transceiver 530 should be powered on or powered off, the controller 550 may power on the wireless transceiver 530 by driving a high voltage potential onto the conductor coupling the output of the regulator 456 to the gate of the MOSFET 440b through the resistor 452b, or may power off the wireless transceiver 530 by driving a low voltage potential onto that conductor.

It should be noted that although much of the discussion of the power control features, including actions taken by the controller 550 in response to changing circumstances to turn on or off components, and including the latching interaction and zero power drain of the MOSFETs 410 and 440 in conjunction with the switch 430, has centered on the headset 1000, and even more particularly to the user of the headset 1000 with an intercom of an airplane, it should be noted that these power control features may also be employed in other personal audio devices. Such other personal audio devices include, but are not limited to, headphones (including in-ear, over-the-ear, and around-the-ear variants), walkie talkies, corded microphones for two-way radios, wireless headsets, pairs of headphones (with or without ANR capability), etc. These features are believed to be of use in any form of personal audio device in which there is need to conserve electric power provided by a power source of limited capacity.

Other embodiments and implementations are within the scope of the following claims and other claims to which the applicant may be entitled.

## Claims

1. An apparatus comprising:
a plurality of normally-open manually operable switches (430a-430c);
a first MOSFET (410) having a first gate coupled to each switch of the plurality of switches, and a first source coupled to a high voltage potential terminal of a power source (552) to receive electric power therefrom;
a second MOSFET (440) having a second source coupled to a low voltage potential terminal of the power source; a second drain also coupled to the first gate of the first MOSFET, and a second gate to receive electric power from the power source (552) through at least the first source and a first drain of the first MOSFET (410);
a controller (550) coupled to the first drain and comprising a plurality of switch inputs, wherein each switch of the plurality of switches is coupled to a switch input of the plurality of switch inputs; and
wherein the apparatus is arranged such that closing one of the switches of the plurality of switches couples the first gate to the low potential voltage terminal of the power source, placing the first MOSFET (410) into a conductive state, providing a high voltage potential through the first MOSFET (410) to the second gate and to the controller, placing the second MOSFET (440) into a conductive state, thereby providing a low voltage potential to the first gate to latch the first and the second MOSFETs in a conductive state, in response to which the controller is arranged to latch the state of the plurality of switch inputs and to identify which one of the switches was closed.

2. The apparatus of claim 1, wherein:
each switch of the plurality of switches is a manually-operable control enabling a user of the apparatus to control an aspect of a function of the apparatus; and
the controller comprises a processing device executing a sequence of instructions stored within the controller and causing the processing device to act in response to a user manually operating the one of the switches identified as closed.

3. The apparatus of claim 1, wherein:
the first drain is coupled to the second gate through a resistor;
the controller further comprises an off output coupled to the second gate enabling the controller drive a low voltage potential to the second gate to place the second MOSFET into a non-conductive state to cause the first and second MOSFETs to cease to be latched in a conductive state.

4. The apparatus of claim 1, wherein the second drain and the first gate are coupled through a normally closed switch that is manually operable to cause the first and second MOSFETs to cease to be latched in a conductive state.

5. A method of operating an apparatus comprising:
waiting for a provision of electric power from a power source (552) caused by a latching interaction of a first MOSFET (410) and a second MOSFET (440) triggered by one normally open switch of a plurality of switches (430a-430-c) being closed; and
in a controller (550), latching the state of each switch of the plurality of switches and identifying a switch that was closed to trigger the latching interaction of the first and second MOSFETs.

6. The method of claim 5, wherein:
each switch of the plurality of switches is designated as a manually-operable control enabling a user of the apparatus to control an aspect of a function of the apparatus; and
the method further comprises acting as indicated by a user having manually operated one of the switches identified as closed.

7. The method of claim 5, further comprising providing a low potential to a gate of the second MOSFET to place the second MOSFET into a non-conductive state to disrupt the latching interaction of the first and second MOSFETs.

## Patentansprüche

1. Gerät, das Folgendes umfasst:
eine Mehrzahl normalerweise offener manuell betätigbarer Schalter (430a-430c),
einen ersten MOSFET (410), der ein erstes Gate hat, das mit jedem Schalter der Mehrzahl von Schaltern gekoppelt ist, und eine erste Source, die mit einer Hochspannungspotenzialklemme einer Leistungsquelle (552) gekoppelt ist, um davon elektrische Leistung zu empfangen,
einen zweiten MOSFET (440), der eine zweite Source hat, die mit einer Niederspannungspotenzialklemme der Stromquelle gekoppelt ist, einen zweiten Drain, der auch mit dem ersten Gate des ersten MOSFET gekoppelt ist, und ein zweites Gate zum Empfangen elektrischer Leistung von der Leistungsquelle (552) durch mindestens die erste Source und einen ersten Drain des ersten MOSFET (410), einen Controller (550), der mit dem ersten Drain gekoppelt ist und eine Mehrzahl von Schaltereingängen umfasst, wobei jeder Schalter der Mehrzahl von Schaltern mit einem Schaltereingang der Mehrzahl von Schaltereingängen gekoppelt ist, und
wobei das Gerät derart eingerichtet ist, dass das Schließen eines der Schalter der Mehrzahl von Schaltern das erste Gate mit der Niederpotenzialspannungsklemme der Leistungsquelle koppelt, wodurch der erste MOSFET (410) in einen leitenden Zustand platziert wird, der ein Hochspannungspotenzial durch den ersten MOSFET (410) zu dem zweiten Gate und zu dem Controller bereitstellt, was den zweiten MOSFET (440) in einen leitenden Zustand platziert, wodurch ein Niederspannungspotenzial zu dem ersten Gate bereitgestellt wird, um den ersten und den zweiten MOSFET in einem leitenden Zustand zu verriegeln, wobei der Controller eingerichtet ist, um als Reaktion darauf den Zustand der Mehrzahl von Schaltereingängen zu verriegeln, um zu identifizieren, welcher der Schalter geschlossen wurde.

2. Gerät nach Anspruch 1, wobei:
jeder Schalter der Mehrzahl von Schaltern eine manuell betätigbare Steuerung ist, die es einem Benutzer des Geräts erlaubt, einen Aspekt einer Funktion des Geräts zu steuern, und
der Controller eine Verarbeitungsvorrichtung umfasst, die eine Sequenz von Anweisungen ausführt, die in dem Controller gespeichert ist und die Verarbeitungsvorrichtung veranlasst, als Reaktion darauf zu handeln, dass ein Benutzer manuell den einen der als geschlossen identifizierten Schalter, die als geschlossen identifiziert wurden, betätigt.

3. Gerät nach Anspruch 1, wobei:
der erste Drain mit dem zweiten Gate durch einen Widerstand gekoppelt ist,
der Controller ferner einen Aus-Ausgang umfasst, der mit dem zweiten Gate gekoppelt ist, was den Controller befähigt, ein Niederspannungspotenzial zu dem zweiten Gate zu treiben, um den zweiten MOSFET in einen nicht leitenden Zustand zu versetzen, um den ersten und den zweiten MOSFET zu veranlassen, nicht mehr in einem leitenden Zustand verriegelt zu sein.

4. Gerät nach Anspruch 1, wobei der zweite Drain und das erste Gate durch einen normalerweise geschlossenen Schalter gekoppelt sind, der manuell betätigbar ist, um den ersten und den zweiten MOSFET zu veranlassen, nicht mehr in einem leitenden Zustand verriegelt zu sein.

5. Verfahren zum Betreiben eines Geräts, das Folgendes umfasst:
Warten auf eine Bereitstellung elektrischer Leistung von einer Leistungsquelle (552), die durch eine Verriegelungswechselwirkung eines ersten MOSFET (410) und eines zweiten MOSFET (440) verursacht wird, die dadurch ausgelöst wird, dass ein normalerweise offener Schalter einer Mehrzahl von Schaltern (430a-130c) geschlossen wird, und
in einem Controller (550) Verriegeln des Zustands jedes Schalters der Mehrzahl von Schaltern und Identifizieren eines Schalters, der geschlossen wurde, um die Verriegelungswechselwirkung des ersten und des zweiten MOSFET auszulösen.

6. Verfahren nach Anspruch 5, wobei
jeder Schalter der Mehrzahl von Schaltern als eine manuell betätigbare Steuerung bezeichnet ist, die einen Benutzer des Geräts befähigt, einen Aspekt einer Funktion des Geräts zu steuern, und
wobei das Verfahren ferner das Handeln wie von einem Benutzer angegeben, der manuell einen der Schalter betätigt hat, der als geschlossen identifiziert wurde, umfasst.

7. Verfahren nach Anspruch 5, das ferner das Bereitstellen eines niedrigen Potenzials zu einem Gate des zweiten MOSFET umfasst, um den zweiten MOSFET in einen nicht leitenden Zustand zu platzieren, um die Verriegelungswechselwirkung des ersten und des zweiten MOSFET zu unterbrechen.

## Revendications

1. Appareil comprenant :
une pluralité d'interrupteurs actionnables manuellement normalement ouverts (430a-430c) ;
un premier MOSFET (410) ayant une première grille couplée à chaque interrupteur de la pluralité d'interrupteurs, et une première source couplée à une borne de potentiel haute tension d'une source d'alimentation (552) pour recevoir une puissance électrique à partir de celle-ci ;
un second MOSFET (440) ayant une seconde source couplée à une borne de potentiel basse tension de la source d'alimentation ; un second drain également couplé à la première grille du premier MOSFET, et une seconde grille pour recevoir une puissance électrique de la source d'alimentation (552) par le biais d'au moins la première source et d'un premier drain du premier MOSFET (410) ;
une unité de commande (550) couplée au premier drain et comprenant une pluralité d'entrées d'interrupteurs, dans laquelle chaque interrupteur de la pluralité d'interrupteurs est couplé à une entrée d'interrupteur de la pluralité d'entrées d'interrupteurs ; et
dans lequel l'appareil est conçu de telle sorte que la fermeture d'un des interrupteurs de la pluralité d'interrupteurs couple la première grille à la borne de tension à faible potentiel de la source d'alimentation, plaçant le premier MOSFET (410) dans un état conducteur, fournissant un potentiel haute tension par le biais du premier MOSFET (410) à la seconde grille et à l'unité de commande, plaçant le second MOSFET (440) dans un état conducteur, fournissant ainsi un potentiel basse tension à la première grille pour verrouiller le premier et le second MOSFET dans un état conducteur, en réponse à quoi l'unité de commande est conçue pour verrouiller l'état de la pluralité d'entrées d'interrupteurs et pour identifier lequel des interrupteurs a été fermé.

2. Appareil selon la revendication 1, dans lequel :
chaque interrupteur de la pluralité d'interrupteurs est une commande actionnable manuellement permettant à un utilisateur de l'appareil de commander un aspect d'une fonction de l'appareil ; et
l'unité de commande comprend un dispositif de traitement exécutant une séquence d'instructions stockée à l'intérieur de l'unité de commande et amenant le dispositif de traitement à agir en réponse à un actionnement manuel par l'utilisateur de l'un des interrupteurs identifiés comme fermés.

3. Appareil selon la revendication 1, dans lequel :
le premier drain est couplé à la seconde grille par le biais d'une résistance ;
l'unité de commande comprend en outre une sortie fermée couplée à la seconde grille permettant à l'unité de commande de conduire un potentiel basse tension vers la seconde grille pour placer le second MOSFET dans un état non conducteur pour amener les premier et second MOSFET à cesser d'être verrouillés dans un état conducteur.

4. Appareil selon la revendication 1, dans lequel le second drain et la première grille sont couplés par le biais d'un interrupteur normalement fermé qui est actionnable manuellement pour amener les premier et second MOSFET à cesser d'être verrouillés dans un état conducteur.

5. Procédé de fonctionnement d'un appareil comprenant :
l'attente d'une fourniture de puissance électrique à partir d'une source d'alimentation (552) causée par une interaction de verrouillage d'un premier MOSFET (410) et d'un second MOSFET (440) déclenchée par un interrupteur normalement ouvert d'une pluralité d'interrupteurs (430a-430c) étant fermés ; et
dans une unité de commande (550), le verrouillage de l'état de chaque interrupteur de la pluralité d'interrupteurs et l'identification d'un interrupteur qui a été fermé pour déclencher l'interaction de verrouillage des premier et second MOSFET.

6. Procédé selon la revendication 5, dans lequel :
chaque interrupteur de la pluralité d'interrupteurs est désigné comme une commande actionnable manuellement permettant à un utilisateur de l'appareil de commander un aspect d'une fonction de l'appareil ; et
le procédé comprend en outre l'action telle qu'indiquée par un utilisateur ayant actionné manuellement l'un des interrupteurs identifiés comme fermés.

7. Procédé selon la revendication 5, comprenant en outre la fourniture d'un faible potentiel à une grille du second MOSFET pour placer le second MOSFET dans un état non conducteur pour interrompre l'interaction de verrouillage des premier et second MOSFET.
